# EUROPEAN PATENT SPECIFICATION

(11) **EP 2 053 030 B1**
(45) Date of publication and mention of the grant of the patent: **12.10.2011**
(21) Application number: 07791260.8
(22) Date of filing: 25.07.2007
(51) Int. Cl.: C04B 35/64, B32B 18/00, H05K 3/46

(54) **PROCESS FOR PRODUCTION OF FORMED CERAMIC BODIES**
VERFAHREN ZUR HERSTELLUNG VON KERAMIKFORMKÖRPERN
PROCÉDÉ DE FABRICATION DE CORPS EN CÉRAMIQUE MOULÉS

(30) Priority: 18.08.2006 JP 2006223559
(43) Date of publication of application: 29.04.2009
(73) Proprietor: Murata Manufacturing Co. Ltd., Nagaokakyo-shi, Kyoto 617-8555 (JP)
(72) Inventor: MURATA, Takaki, Nagaokakyo-shi Kyoto 617-8555 (JP)
(74) Representative: Zimmermann, Tankred Klaus
(86) International application number: PCT/JP2007/064542
(87) International publication number: WO 2008/020534

(56) References cited:
- EP-A1- 0 479 219
- JP-A- 10 095 677
- JP-A- 59 107 980
- JP-A- 2001 291 959
- JP-A- 2004 323 306
- US-A1- 2004 159 390

## Description

### Technical Field

The present invention relates to methods for producing ceramic compacts such as ceramic substrates and particularly relates to a method for producing a ceramic compact, such as a ceramic substrate, obtained through a so-called constraint firing step in which an unfired body is attached to a constraining layer and then fired such that the transverse shrinkage of the unfired body is prevented.

### Background Art

Ceramic electronic components, particularly ceramic substrates, need to have high two-dimensional accuracy. The transverse shrinkage of the ceramic electronic components fired in firing steps and the variation in shrinkage seriously affect product quality.

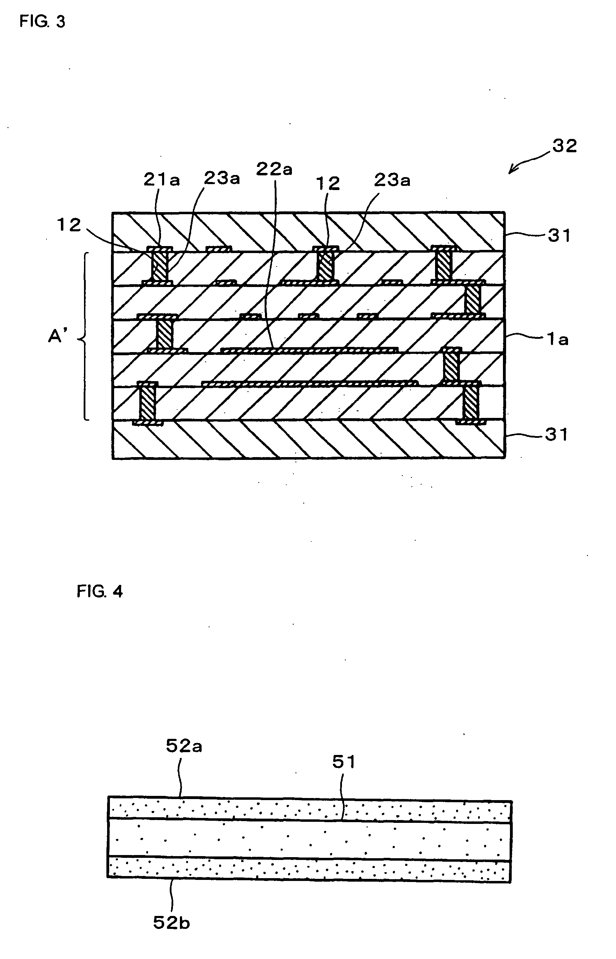

There are some methods in which ceramic compacts are fired so as to be prevented from shrinking in firing steps. For example, the following method has been proposed: a firing method (hereinafter referred to as constraint firing) in which a ceramic compact 51 is fired so as to be substantially prevented from transversely shrinking in such a manner that both principal surfaces of the ceramic compact 51 are covered with layers (constraining layers) 52a and 52b principally containing a sintering-resistant material such as alumina as shown in Fig. 4, the sintering-resistant material being not substantially sintered at the firing temperature of the ceramic compact 51 (see Patent Document 1).

In the conventional firing method, the constraining layers, which are not sintered and remain on the ceramic compact 51, need to be physically or mechanically removed by wet blasting or another process after the firing step is finished. This is a problem in that production steps are complicated.

Since recent electronic components are compact and therefore thin ceramic substrates and elements are demanded, there is a problem in that if the conventional firing method is used to produce a multilayer ceramic substrate, the substrate cracks in a step of removing constraining layers.
Patent Document 1: Japanese Unexamined Patent Application Publication No. 4-243978

### Disclosure of Invention

### Problems to be Solved by the Invention

The present invention has been made to solve the above problems. It is an object of the present invention to provide a method for securely and efficiently producing a ceramic compact with high dimensional accuracy. In the method, no constraining layer needs to be removed after the finish of a firing step, production steps are simple, and a fired body is prevented from cracking in a step of removing a constraining layer.

### Means for Solving the Problems

In order to solve the above problems, a method for producing a ceramic compact as specified in Claim 1 includes a laminate-preparing step of preparing an unfired laminate including a base layer containing a ceramic powder and a glass material and a constraining layer that is in contact with at least one principal surface of the base layer and that principally contains a burnable material which does not burn off when the burnable material is fired in a low-oxygen atmosphere but which burns off when the burnable material is fired at an oxygen partial pressure greater than that of the low-oxygen atmosphere and also includes a firing step of firing the unfired laminate to sinter the base layer. The firing step includes a first firing sub-step of firing the laminate including the constraining layer to sinter the base layer and a second firing sub-step of performing firing at an oxygen partial pressure greater than that of the first firing sub-step such that the burnable material contained in the constraining layer burns off.

A method for producing a ceramic compact as specified in Claim 2 is characterized in that the ceramic compact is a ceramic substrate.

A method for producing a ceramic compact as specified in Claim 3 is characterized in that in the configuration of Claim 1 or 2, firing is performed in the first firing sub-step such that the glass material contained in the base layer penetrates the constraining layer.

A method for producing a ceramic compact as specified in Claim 4 is characterized in that in the configuration of any one of Claims 1 to 3, the burnable material is a carbon powder.

A method for producing a ceramic compact as specified in Claim 5 is characterized in that in the configuration of any one of Claims 1 to 4, the base layer contains a binder, the method further includes a degreasing step of removing the binder from the base layer, and the degreasing step is prior to the first firing sub-step of the firing step and is performed in an oxygen-containing atmosphere at a temperature at which the burnable material does not burn off.

A method for producing a ceramic compact as specified in Claim 6 is characterized in that in the configuration of any one of Claims 1 to 5, the constraining layer is formed in the laminate-preparing step in such a manner that a sheet principally containing the burnable material is provided on at least one principal surface of the base layer.

A method for producing a ceramic compact as specified in Claim 7 is characterized in that in the configuration of any one of Claims 1 to 6, the constraining layer is formed in the laminate-preparing step in such a manner that a paste principally containing the burnable material is applied onto at least one principal surface of the base layer.

A method for producing a ceramic compact as specified in Claim 8 is characterized in that in the configuration of any one of Claims 1 to 7, the base layer has a multilayer structure including sub-layers containing the ceramic powder and the glass material.

A method for producing a ceramic compact as specified in Claim 9 is characterized in that in the configuration of any one of Claims 1 to 8, the base layer has a wiring pattern disposed on at least one principal surface thereof.

In the configuration of any one of Claims 1 to 9, a method for producing a ceramic compact as specified in Claim 10 is characterized in further including a step of mounting an electronic component on an outer surface of the base layer fired in the firing step.

### Advantages

In the ceramic compact-producing method of Claim 1, the constraining layer, which principally contain the burnable material which does not burn off when the burnable material is fired in a low-oxygen atmosphere but which burns off when the burnable material is fired at an oxygen partial pressure greater than that of the low-oxygen atmosphere, is used.

After firing is performed in the low-oxygen atmosphere in the first firing sub-step such that the base layer is sintered without causing the transverse shrinkage of the base layer, the burnable material contained in the constraining layer can burn off in the second firing sub-step in such a manner that firing is performed at an oxygen partial pressure greater than that of the first firing sub-step; hence, the constraining layer can be substantially removed in the firing step. Unlike the method which is disclosed in Patent Document 1 and in which constraint firing is performed, the method of Claim 1 requires no step of removing the constraining layer by a physical or mechanical process such as a wet blasting process after the finish of the firing step and steps of the method are simple. Unlike the method in which constraint firing is performed using the conventional constraining layers, the method of Claim 1 is effective in preventing a fired body from cracking or chipping in a constraining layer-removing step.

Therefore, according to the present invention, ceramic substrates having high dimensional accuracy can be produced at high yield.

In the ceramic compact-producing method according to the present invention, the constraining layer exhibits a binding force to prevent the base layer from shrinking in the transverse direction (in the direction parallel to a principal surface thereof) in the first firing sub-step (constraint firing step). The binding force thereof prevents the base layer from shrinking in the transverse direction thereof but allows the base layer to shrink substantially only in the thickness direction thereof. Therefore, a ceramic compact having high two-dimensional accuracy can be securely produced.

The term "low-oxygen atmosphere" used herein means an atmosphere having an oxygen partial pressure considerably less than that of air and particularly refers to an atmosphere that has an oxygen partial pressure of, for example, about 10⁻² atm or less (that is, the concentration of oxygen in this atmosphere is about 1% by volume or less) at atmospheric pressure.

The low-oxygen atmosphere preferably has an oxygen partial pressure of, for example, 10⁻⁶ to 10⁻³ atm (an oxygen concentration of 0.0001% to 0.1% by volume) at atmospheric pressure.

In the second firing sub-step, a condition greater than the oxygen partial pressure of the first firing sub-step means an atmosphere having an oxygen partial pressure sufficient to allow the burnable material to burn off and particularly refers to an atmosphere that has an oxygen partial pressure of, for example, about 10⁻¹ atm or more (that is, the concentration of oxygen in this atmosphere is about 10% by volume or more) at atmospheric pressure. The concentration of oxygen in this atmosphere may be 100% by volume but the upper limit of the oxygen concentration thereof is preferably equal to the oxygen concentration of air (an oxygen partial pressure of 0.21 atm) in view of manufacturing cost.

As specified in Claim 2, the present invention is suitable for a method for producing a ceramic substrate which preferably has high two-dimensional accuracy and shape accuracy. A method according to the present invention is useful in efficiently producing a ceramic substrate having high dimensional accuracy.

In the ceramic compact-producing method of Claim 3, the glass material contained in the base layer penetrates the constraining layer in the first firing sub-step to form a permeation layer. This allows the constraining layer and the base layer to be tightly bonded to each other with the permeation layer disposed therebetween. The permeation layer securely inhibits or prevents the transverse shrinkage of the base layer in the first firing sub-step.

In order to securely achieve a binding force, the glass material in the base layer preferably securely penetrates the constraining layer. Therefore, the constraining layer is preferably tightly attached to the base layer.

In the ceramic compact-producing method of Claim 4, the carbon powder, which is the burnable material, does not burn or shrink in the first firing sub-step although the carbon powder is fired in the low-oxygen atmosphere; hence, the carbon powder exhibits a function of preventing the shrinkage of the base layer during firing. The carbon powder burns off when the carbon powder is fired at a high oxygen partial pressure in the second firing sub-step. Therefore, no step of removing the constraining layer needs to be performed after the finish of the second firing sub-step. Furthermore, various ceramic compacts, such as ceramic substrates, having high dimensional accuracy can be efficiently produced. This proves the present invention to be effective.

The carbon powder preferably has a particle size of 0.1 to 100 µm. When the particle size thereof is 100 µm or less, a large binding force can be achieved. When the particle size thereof is 0.1 µm or more, the carbon powder readily burns off in the second firing sub-step. The carbon powder more preferably has a particle size of 1 to 5 µm. When the particle size thereof is 5 µm or less, a binding force can be securely achieved. When the particle size thereof is 1 µm or more, the carbon powder more readily burns off.

In the ceramic compact-producing method of Claim 5, the degreasing step is prior to the first firing sub-step of the firing step and is performed in the oxygen-containing atmosphere at a temperature at which the burnable material does not burn off; hence, the binder contained in the base layer can be securely removed in the degreasing step, so that the first firing sub-step, in which constraint firing is performed, and the second firing sub-step, in which the burnable material contained in the constraining layer burns off, can be smoothly performed.

Examples of the oxygen-containing atmosphere, in which the degreasing step is performed, include air atmospheres and atmospheres containing inert gases and air. An air atmosphere having a high oxygen partial pressure is useful in efficiently removing the binder.

In the present invention, examples of a technique for forming the constraining layer include a technique in which the burnable material-containing sheet is prepared in advance and then provided on at least one principal surface of the base layer as specified in Claim 6 and a technique in which the burnable material-containing paste is applied onto at least one principal surface of the base layer as specified in Claim 7.

In order to securely achieve a binding force, the constraining layer is preferably tightly bonded to the base layer such that the glass material contained in the base layer penetrates the constraining layer to securely form the permeation layer as described above. In the case where the constraining layer is formed in such a manner that a carbon sheet principally containing the carbon powder is deposited on the base layer, the carbon sheet is preferably pressed against the base layer. In the case where the constraining layer is formed in such a manner that a carbon paste principally containing the carbon powder is applied onto the base layer, the carbon paste is preferably pressurized such that the carbon paste adheres tightly to the base layer.

As described in the ceramic compact-producing method of Claim 8, the base layer has the multilayer structure; hence, various ceramic compacts, such as ceramic substrates, having high two-dimensional accuracy and shape accuracy can be efficiently produced.

In the ceramic compact-producing method of Claim 9, the wiring pattern is disposed on at least one principal surface of the base layer. Therefore, if a ceramic compact produced by this method is used, the ceramic compact, or a ceramic substrate, can be efficiently processed so as to have an electronic component disposed on an outer surface thereof in such a manner that the electronic component is provided on the base layer fired in the firing step as specified in Claim 10.

### Brief Description of Drawings

[Fig. 1] Fig. 1 is an illustration of a ceramic substrate (multilayer ceramic substrate) produced by a method according to an embodiment (first embodiment) of the present invention.
[Fig. 2] Fig. 2 is an illustration of a situation in which surface-mounted components are placed on the ceramic substrate shown in Fig. 1.
[Fig. 3] Fig. 3 is an illustration of an unfired laminate including constraining layers prepared in a step of the method for producing the ceramic substrate shown in Figs. 1 and 2.
[Fig. 4] Fig. 4 is an illustration of a conventional method for constraint-firing a ceramic compact using constraining layers principally containing a sintering-resistant material. Reference Numerals
   - 1: insulating ceramic layers
   - 1a: substrate-use ceramic green sheets
   - 2: conductive sections
   - 3a and 3b: surface-mounted electronic components
   - 12: through-holes
   - 21: surface conductors (external conductors)
   - 21a: unsintered external conductors
   - 22: interlayer conductors (internal conductors)
   - 22a: unsintered internal conductors
   - 23: via-hole conductors
   - 23a: unsintered via-hole conductors
   - 31: constraining layers

   - 32: unfired laminate
   - A: ceramic substrate (multilayer ceramic substrate)
   - A': base layer (unfired ceramic substrate)
   - B: ceramic substrate (multilayer ceramic substrate)

### Best Modes for Carrying Out the Invention

Preferred embodiments of the present invention will now be described.

### (1) Constraining Layer

A constraining layer used in a method for producing a ceramic compact according to the present invention needs to have the following two features:
(a) the constraining layer maintains a function of preventing the shrinkage of a base layer until a low-temperature sinterable ceramic material contained in the base layer is sintered, that is, until a first firing step of firing the base layer in a low-oxygen atmosphere is finished, and
(b) the constraining layer burns off in a second firing step of firing the base layer at an oxygen partial pressure greater than that of the first firing step.

The constraining layer preferably contains a burnable material, for example, carbon powder.

The burnable material such as carbon powder preferably has properties allowing the constraining layer, which principally contains the burnable material, to have a sufficient binding force, that is, properties allowing the constraining layer to prevent the shrinkage of the base layer in the first firing step.

The burnable material, which is contained in the constraining layer, preferably has a high combustion temperature so as not to burn in the first firing step.
When the burnable material has a high combustion temperature, the constraining layer can be securely degreased by increasing the heating temperature of the constraining layer in a degreasing step and a binder used can be selected from a wide variety of materials. The burnable material such as carbon powder preferably has a combustion temperature of 600°C or more.

In order to allow the constraining layer to have a sufficient binding force, the base layer preferably contains a glass material that penetrates the constraining layer to form a permeation layer. Therefore, the constraining layer is preferably tightly attached to the base layer such that the glass material securely penetrates the constraining layer. In the case where the constraining layer is formed by depositing a constraining layer-use sheet on the base layer, the sheet is preferably pressed against the base layer. In the case where the constraining layer is formed by a coating process using a paste, the paste is preferably applied onto the base layer in such a manner that a printing tool is pressed against the base layer so as to tightly adhere thereto.

Carbon powder, which is an example of the burnable material, preferably has a particle size of 1 to 5 µm. When the particle size thereof is 5 µm or less, a large binding force can be achieved. When the particle size thereof is 1 µm or more, the carbon powder readily burns off in the second firing step.

The constraining layer is fired in an atmosphere which is supplied with air and which therefore has a high oxygen partial pressure in the second firing step subsequent to the first firing step, so that the constraining layer burns off. In order to readily burn off the constraining layer in the second firing step, it is preferable that the constraining layer be preferably formed from the carbon powder, the binder, and a solvent and the number of other additives used be preferably small.

### (2) Degreasing Step

The degreasing step can be usually performed in such a manner that the constraining layer is heated from room temperature to the decomposition or combustion temperature of the binder in air and then maintained at this temperature for a predetermined time.

The constraining layer can be degreased in such a manner that the constraining layer is heated from room temperature to, for example, 400°C and then maintained at this temperature for 60 minutes.

In the ceramic compact-producing method according to the present invention, the degreasing step is preferably performed in an atmosphere, such as an air atmosphere, having a high oxygen partial pressure because high degreasing efficiency can be achieved. However, the degreasing step may be performed at an oxygen partial pressure less than that of air. The degreasing step can be performed in a low-oxygen atmosphere having an oxygen partial pressure considerably less than that of air in some cases.

### (3) Firing Conditions

(a) After the degreasing step is finished, the first firing step is performed in such a manner that the base layer is heated to the sintering temperature thereof, for example, 870°C in an atmosphere supplied with nitrogen.
   In the present invention, a low-oxygen atmosphere used in the first firing step is referred to as an atmosphere having an oxygen partial pressure less than that of air and preferably has an oxygen partial pressure of 10⁻⁶ to 10⁻³ atm because the base layer can be securely constrained without causing the constraining layer to burn off.
(b) After the first firing step is finished, the second firing step is preferably performed in such a manner that the constraining layer is fired in an atmosphere supplied with air. The constraining layer is fired for ten minutes in a temperature range from room temperature to, for example, 780°C. This allows the constraining layer to burn off.
   The first and second firing steps may be performed at different temperatures as described above or the same temperature. The first and second firing steps may be continuously performed. Alternatively, after the first firing step is finished, the second firing step may be performed in such a manner that the base layer and the constraining layer are once taken out of a furnace and then placed into the furnace again.
   Features of the present invention will now be described in detail with reference to embodiments of the present invention.

### First embodiment

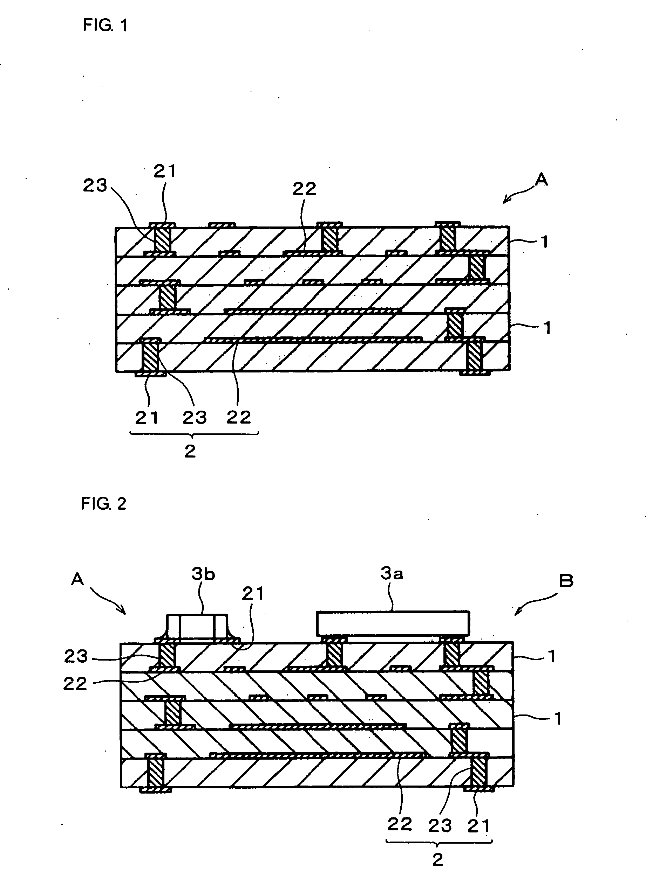

Fig. 1 is an illustration of a ceramic substrate (multilayer ceramic substrate) produced by a method according to an embodiment (first embodiment) of the present invention. Fig. 2 is an illustration of a situation in which surface-mounted components are placed on the ceramic substrate shown in Fig. 1. Fig. 3 is an illustration of an unfired laminate including constraining layers prepared in a step of the method for producing the ceramic substrate shown in Figs. 1 and 2.

The ceramic substrate A shown in Fig. 1 includes insulating ceramic layers 1 formed by firing a low-temperature sinterable ceramic composition containing a ceramic powder and a glass material and also includes conductive sections 2 attached to the insulating ceramic layers 1. The ceramic substrate A is a type of multilayer substrate having a multilayer structure in which a number of the insulating ceramic layers 1 are stacked.

The low-temperature sinterable ceramic composition, which is used to form the insulating ceramic layers 1, contains, for example, an aluminum-based ceramic powder and a borosilicate glass-based glass powder.

The conductive sections 2 are categorized into surface conductors (external conductors) 21 located on the ceramic substrate A, interlayer conductors (internal conductors) 22 disposed between the insulating ceramic layers 1 bonded to each other, and via-hole conductors 23 for connecting the interlayer conductors 22 to each other or connecting the surface conductors 21 to the interlayer conductors 22.

The surface conductors 21 and the interlayer conductors 22 are formed by firing external conductive layers and internal conductive layers, respectively, formed from a conductive paste (for example, a silver-containing conductive paste) by printing. The via-hole conductors 23 are formed in such a manner that a conductive paste or a conductive powder is packed into via-holes and then fired.

The ceramic substrate (multilayer ceramic substrate) B shown in Fig. 2 is formed by providing surface-mounted electronic components 3a and 3b such as semiconductor elements or chip capacitors on the ceramic substrate (multilayer ceramic substrate) A shown in Fig. 1.

A method for producing the multilayer ceramic substrates A and B will now be described.

The method is described below with reference to Figs. 1 to 3.
(1) Appropriate amounts of a binder, a dispersant, a plasticizer, and the like are added to a powder mixture prepared by mixing a ceramic powder and a glass material. These components are mixed into a ceramic slurry.

The ceramic powder can be selected from various powders and may be, for example, an alumina powder.

The glass material may contain a glass powder or may form glassy precipitates in a firing step. Alternatively, the glass material may form crystalline precipitates in the final stage of the firing step, thereby causing crystallization. The glass material is preferably a borosilicate-based glass powder that can form crystalline precipitates of, for example, forsterite, akermanite, or diopside, which has low dielectric loss.
(2) The ceramic slurry is formed into sheets by a doctor blade process or the like, whereby substrate-use ceramic green sheets 1a (Fig. 3) are prepared.
(3) Through-holes 12 (Fig. 3) for forming the via-hole conductors are formed in the substrate-use ceramic green sheets (substrate-use green sheets) 1a as required. The conductive paste or the conductive powder is packed into the through-holes 12, whereby unsintered via-hole conductors 23a (Fig. 3) are formed (in the first embodiment, the conductive paste is packed into the through-holes 12).
(4) For example, a silver-containing conductive paste is applied onto the substrate-use ceramic green sheets 1a by printing as required, whereby unsintered surface conductors 21a and unsintered internal conductors 22a are formed (see Fig. 3).
(5) Appropriate amounts of a binder, an organic solvent, and the like are added to a burnable material that does not burn off in a predetermined low-oxygen atmosphere but burns off when the burnable material is fired at an oxygen partial pressure greater than that of the low-oxygen atmosphere. These components are mixed into a constraining layer-use slurry. This slurry is formed into sheets by a doctor blade process or the like, whereby constraining layer-use green sheets are obtained.

The constraining layers may be identical to the constraining layer described in Sub-item "(1) Constraining Layer" of Item "Best Modes for Carrying Out the Invention".

In particular, the burnable material is preferably, but not limited to, a carbon powder.

The constraining layers 31 preferably have a thickness of 100 to 200 µm. This is because when the thickness thereof is 100 µm or more, the constraining layers can independently function well. Alternatively, when the thickness thereof is 200 µm or less, the sheets can be readily formed.

In this embodiment, the constraining layer-use green sheets are prepared for the constraining layers. However, for example, a paste containing a carbon powder, a binder, and an organic solvent may be applied onto at least one principal surface of a base layer (unfired ceramic substrate) A', having a multilayer structure, shown in Fig. 3.
(6) As shown in Fig. 3, the substrate-use ceramic green sheets 1a are stacked in a predetermined order and the constraining layers 31 are provided on principal surfaces of the base layer (unfired ceramic substrate) A', which has a multilayer structure formed by stacking the substrate-use ceramic green sheets 1a, and then pressed against the principal surfaces thereof, whereby an unfired laminate 32 having a structure in which the constraining layers 31 are disposed on the upper and lower surfaces of the base layer (unfired ceramic substrate) A' (see Fig. 3).

The unfired laminate 32 may be cut so as to have an appropriate size as required.

In the first embodiment, the base layer A', which has the multilayer structure, is prepared by stacking the substrate-use ceramic green sheets 1a. The base layer A' may be prepared from one of the substrate-use ceramic green sheets 1a so as to have a single-layer structure and then processed into a single-plate ceramic substrate.

In the first embodiment, the constraining layers 31 are placed on the upper and lower surfaces of the base layer (unfired ceramic substrate) A'. However, one of the constraining layers 31 may be placed on only one of the principal surfaces of the base layer (unfired ceramic substrate) A'.
(7) The unfired laminate 32 is fired in a low-oxygen atmosphere in which a low-temperature sinterable ceramic material contained in the substrate-use ceramic green sheets 1a included in the base layer (unfired ceramic substrate) A' is sintered and in which the burnable material contained in the constraining layers 31 does not burn off but exhibits a function of preventing the transverse shrinkage of the base layer A', whereby the unfired base layer (ceramic substrate) is sintered (a first firing step). The constraining layers 31 are fired at an oxygen partial pressure greater than that of the first firing step such that the burnable material contained in the constraining layers 31 burns off (a second firing step).

This allows a ceramic substrate A having a configuration shown in Fig. 1 to be obtained.

### [Example]

Eight parts by weight of a binder, one part by weight of a dispersant, three parts by weight of a plasticizer, and 80 parts by weight of an organic solvent were added to 100 parts by weight of a powder mixture prepared by mixing 48% by weight of a ceramic powder and 52% by weight of a glass powder. These components were mixed into a ceramic slurry.

In this example, the ceramic powder was an alumina (Al₂O₃) powder and the glass powder was a borosilicate glass powder.

The ceramic slurry was formed into sheets by a doctor blade process, whereby substrate-use ceramic green sheets 1a (see Fig. 3) having a thickness of 50 µm were prepared.

Through-holes 12 for forming via-hole conductors were formed in the substrate-use ceramic green sheets 1a. A silver-containing conductive paste was packed into the through-holes 12, whereby via-hole conductors 23a were formed.

The silver-containing conductive paste was applied onto the substrate-use ceramic green sheets by printing, whereby unsintered surface conductors 21a and unsintered internal conductors (interconnecting conductive layers) 22a were formed.

To 100 parts by weight of a carbon powder with a particle size of 2 µm, 12 parts by weight of a binder, one part by weight of a dispersant, four parts by weight of a plasticizer, and 100 parts by weight of an organic solvent were added. These components were mixed into a constraining layer-use slurry. The constraining layer-use slurry was formed into sheets by a doctor blade process, whereby constraining layers (constraining layer-use green sheets) with a thickness of 100 µm were prepared.

Ten of the substrate-use ceramic green sheets 1a were arranged in a predetermined order. The constraining layers 31 were provided on the upper and lower surfaces of a laminate (an unpressed, unfired base layer) including these substrate-use ceramic green sheets and then pressed against the laminate, whereby an unfired laminate 32 was prepared.

The unfired laminate was heated from room temperature to 400°C at a rate of 1°C/min in air and then maintained at this temperature for one hour, whereby the unfired laminate was degreased (a degreasing step). The unfired laminate was heated from 400°C to 870°C at a rate of 1°C/min in an atmosphere, supplied with nitrogen, having an oxygen partial pressure of 10⁻⁵ atm and then maintained at 870°C for ten minutes (a first firing step).

The atmosphere was supplied with air at atmospheric pressure and maintained at an oxygen partial pressure of 0.21 atm for ten minutes such that the constraining layers 31 burned off, whereby a ceramic substrate A having a configuration shown in Fig. 1 was obtained.

In the first embodiment, in order to produce the ceramic substrate trough a constraint firing step, the constraining layers are used. The constraining layers principally contain the burnable material, which does not burn off when the burnable material is fired in the low-oxygen atmosphere but burns off when the burnable material is fired at an oxygen partial pressure greater than that of the low-oxygen atmosphere. In the first firing step, constraint firing is performed in the low-oxygen atmosphere such that the base layer is sintered. In the second firing step, firing is performed at an oxygen partial pressure greater than that of the first firing step such that the burnable material contained in the constraining layers burns off. Unlike the method which is disclosed in Patent Document 1 and in which constraint firing is performed using the constraining layers principally containing the sintering-resistant ceramic material, the method of the first embodiment requires no step of removing the constraining layers by a physical or mechanical process such as a wet blasting process after the finish of the firing steps and is effective in preventing a fired body from cracking or chipping in a constraining layer-removing step. Therefore, according to the present invention, ceramic substrates having high dimensional accuracy can be produced at high yield.

In the above embodiment, the production of a ceramic compact is described using the ceramic substrate as an example. The present invention is not limited to the ceramic substrate and can be applied to methods for producing various ceramic compacts including ceramic electronic components such as ceramic coil components and ceramic LC composite components.

The present invention is not limited to the above embodiment. The following items may be modified or varied within the scope of the present invention: the types and mixing ratio of a ceramic powder and glass material used to form a base layer, the type of a burnable material used to form a constraining layer, conditions of a first and a second firing step, and conditions of a degreasing step.

### Industrial Applicability

As described above, according to the present invention, a ceramic compact having high two-dimensional accuracy can be efficiently produced without performing a step of removing a constraining layer after a firing step or without performing complicated steps.

Accordingly, the present invention can be widely used to produce ceramic compacts through firing steps.

## Claims

1. A method for producing a ceramic compact, comprising:
a laminate-preparing step of preparing an unfired laminate (32) including a base layer (A') containing a ceramic powder and a glass material and a constraining layer (31) that is in contact with at least one principal surface of the base layer and that principally contains a burnable material which does not burn off when the burnable material is fired in a low-oxygen atmosphere but which burns off when the burnable material is fired at an oxygen partial pressure greater than that of the low-oxygen atmosphere; and
a firing step of firing the unfired laminate to sinter the base layer,
wherein the firing step includes a first firing sub-step of firing the laminate including the constraining layer to sinter the base layer and a second firing sub-step of performing firing at an oxygen partial pressure greater than that of the first firing sub-step such that the burnable material contained in the constraining layer burns off.

2. The ceramic compact-producing method according to Claim 1, wherein the ceramic compact is a ceramic substrate.

3. The ceramic compact-producing method according to Claim 1 or 2, wherein firing is performed in the first firing sub-step such that the glass material contained in the base layer penetrates the constraining layer.

4. The ceramic compact-producing method according to any one of Claims 1 to 3, wherein the burnable material is a carbon powder.

5. The ceramic compact-producing method according to any one of Claims 1 to 4, wherein the base layer contains a binder, the method further comprising a degreasing step of removing the binder from the base layer, the degreasing step being prior to the first firing sub-step of the firing step and being performed in an oxygen-containing atmosphere at a temperature at which the burnable material does not burn off.

6. The ceramic compact-producing method according to any one of Claims 1 to 5, wherein the constraining layer is formed in the laminate-preparing step in such a manner that a sheet principally containing the burnable material is provided on at least one principal surface of the base layer.

7. The ceramic compact-producing method according to any one of Claims 1 to 6, wherein the constraining layer is formed in the laminate-preparing step in such a manner that a paste principally containing the burnable material is applied onto at least one principal surface of the base layer.

8. The ceramic compact-producing method according to any one of Claims 1 to 7, wherein the base layer has a multilayer structure including sub-layers containing the ceramic powder and the glass material.

9. The ceramic compact-producing method according to any one of Claims 1 to 8, wherein the base layer has a wiring pattern disposed on at least one principal surface thereof.

10. The ceramic compact-producing method according to any one of Claims 1 to 9, further comprising a step of mounting an electronic component on an outer surface of the base layer fired in the firing step.

## Patentansprüche

1. Ein Verfahren zum Herstellen eines kompakten keramischen Körpers, das folgende Schritte aufweist:
einen Laminatvorbereitungsschritt zum Vorbereiten eines ungebrannten Laminats (32), das eine Basisschicht (A') umfasst, die ein Keramikpulver und ein Glasmaterial enthält, und eine Begrenzungsschicht (31), die in Kontakt mit zumindest einer Hauptoberfläche der Basisschicht ist und die im Wesentlichen ein brennbares Material enthält, das nicht abbrennt, wenn das brennbare Material in einer sauerstoffarmen Atmosphäre gebrannt wird, das aber abbrennt, wenn das brennbare Material bei einem Sauerstoffteildruck höher als dem der sauerstoffarmen Atmosphäre gebrannt wird; und
einen Brennschritt zum Brennen des ungebrannten Laminats, um die Basisschicht zu sintern,
wobei der Brennschritt einen ersten Brennteilschritt zum Brennen des Laminats umfasst, das die Begrenzungsschicht umfasst, um die Basisschicht zu sintern, und einen zweiten Brennteilschritt zum Ausführen eines Brennens bei einem Sauerstoffteildruck, der größer ist als der des ersten Brennteilschritts, derart, dass das brennbare Material, das in der Begrenzungsschicht enthalten ist, abbrennt.

2. Das Verfahren zum Herstellen eines kompakten Keramikkörpers gemäß Anspruch 1, bei dem der kompakte Keramikkörper ein Keramiksubstrat ist.

3. Das Verfahren zum Herstellen des kompakten Keramikkörpers gemäß Anspruch 1 oder 2, bei dem das Brennen in dem ersten Brennteilschritt derart ausgeführt wird, dass das Glasmaterial, das in der Basisschicht enthalten ist, die Begrenzungsschicht durchdringt.

4. Das Verfahren zum Herstellen des kompakten Keramikkörpers gemäß einem der Ansprüche 1 bis 3, bei dem das brennbare Material ein Kohlenstoffpulver ist.

5. Das Verfahren zum Herstellen des kompakten Keramikkörpers gemäß einem der Ansprüche 1 bis 4, bei dem die Basisschicht ein Bindemittel enthält, wobei das Verfahren ferner einen Entfettungsschritt zum Entfernen des Bindemittels von der Basisschicht aufweist, wobei der Entfettungsschritt vor dem ersten Brennteilschritt des Brennschritts ist und in einer sauerstoffenthaltenden Atmosphäre bei einer Temperatur ausgeführt wird, bei der das brennbare Material nicht abbrennt.

6. Das Verfahren zum Herstellen des kompakten Keramikkörpers gemäß einem der Ansprüche 1 bis 5, bei dem die Begrenzungsschicht in dem Laminatvorbereitungsschritt auf solche Weise gebildet wird, dass eine Lage, die im Wesentlichen das brennbare Material enthält, auf zumindest einer Hauptoberfläche der Basisschicht vorgesehen ist.

7. Das Verfahren zum Herstellen des kompakten Keramikkörpers gemäß einem der Ansprüche 1 bis 6, bei dem die Begrenzungsschicht in dem Laminatvorbereitungsschritt auf solche Weise gebildet wird, dass eine Paste, die im Wesentlichen das brennbare Material enthält, auf zumindest eine Hauptoberfläche der Basisschicht aufgebracht wird.

8. Das Verfahren zum Herstellen des kompakten Keramikkörpers gemäß einem der Ansprüche 1 bis 7, bei dem die Basisschicht eine Mehrschichtstruktur aufweist, die Teilschichten umfasst, die das Keramikpulver und das Glasmaterial enthalten.

9. Das Verfahren zum Herstellen des kompakten Keramikkörpers gemäß einem der Ansprüche 1 bis 8, bei dem die Basisschicht eine Verdrahtungsstruktur aufweist, die auf zumindest einer Hauptoberfläche derselben angeordnet ist.

10. Das Verfahren zum Herstellen des kompakten Keramikkörpers gemäß einem der Ansprüche 1 bis 9, das ferner einen Schritt zum Befestigen einer Elektronikkomponente auf einer Außenoberfläche der Basisschicht aufweist, die in dem Brennschritt gebrannt wird.

## Revendications

1. Procédé pour produire un comprimé de céramique, comprenant :
une étape de préparation de stratifié consistant à préparer un stratifié vert (32) comprenant une couche de base (A') contenant une poudre de céramique et un matériau en verre et une couche de contrainte (31) qui est en contact avec au moins une surface principale de la couche de base et qui contient principalement un matériau combustible qui ne brûle pas lorsque le matériau combustible est cuit dans une atmosphère à faible teneur en oxygène mais qui brûle lorsque le matériau combustible est cuit à une pression partielle d'oxygène supérieure à celle de l'atmosphère à faible teneur en oxygène ; et
une étape de cuisson consistant à faire cuire le stratifié vert pour fritter la couche de base,
dans lequel l'étape de cuisson comprend une première sous-étape de cuisson consistant à faire cuire le stratifié comprenant la couche de contrainte afin de fritter la couche de base, et une deuxième sous-étape de cuisson consistant à réaliser la cuisson à une pression partielle d'oxygène supérieure à celle de la première sous-étape de cuisson de sorte que le matériau combustible contenu dans la couche de contrainte brûle.

2. Procédé pour produire un comprimé de céramique selon la revendication 1, dans lequel le comprimé de céramique est un substrat en céramique.

3. Procédé pour produire un comprimé de céramique selon la revendication 1 ou 2, dans lequel l'étape de cuisson est réalisée à la première sous-étape de cuisson de sorte que le matériau en verre contenu dans la couche de base pénètre dans la couche de contrainte.

4. Procédé pour produire un comprimé de céramique selon l'une quelconque des revendications 1 à 3, dans lequel le matériau combustible est une poudre de carbone.

5. Procédé pour produire un comprimé de céramique selon l'une quelconque des revendications 1 à 4, dans lequel la couche de base contient un liant, le procédé comprenant en outre une étape de dégraissage consistant à retirer le liant de la couche de base, l'étape de dégraissage ayant lieu avant la première sous-étape de cuisson de l'étape de cuisson et étant réalisée dans une atmosphère contenant de l'oxygène à une température à laquelle le matériau combustible ne brûle pas.

6. Procédé pour produire un comprimé de céramique selon l'une quelconque des revendications 1 à 5, dans lequel la couche de contrainte est formée lors de l'étape de préparation de stratifié de sorte qu'une feuille contenant principalement le matériau combustible est prévue sur au moins une surface principale de la couche de base.

7. Procédé pour produire un comprimé de céramique selon l'une quelconque des revendications 1 à 6, dans lequel la couche de contrainte est formée à l'étape de préparation de stratifié de sorte qu'une pâte contenant principalement le matériau combustible est appliquée sur au moins une surface principale de la couche de base.

8. Procédé pour produire un comprimé de céramique selon l'une quelconque des revendications 1 à 7, dans lequel la
couche de base a une structure multicouche comprenant des sous-couches contenant la poudre de céramique et le matériau en verre.

9. Procédé pour produire un comprimé de céramique selon l'une quelconque des revendications 1 à 8, dans lequel la couche de base a un modèle de câblage disposé sur au moins l'une de ses surfaces principales.

10. Procédé pour produire un comprimé de céramique selon l'une quelconque des revendications 1 à 9, comprenant en outre une étape consistant à monter un composant électronique sur une surface externe de la couche de base cuite lors de l'étape de cuisson.
